# FASCICULE DE BREVET EUROPEEN

(11) **EP 1 962 337 B1**
(45) Date de publication et mention de la délivrance du brevet: **19.09.2018**
(21) Numéro de dépôt: 08101901.0
(22) Date de dépôt: 22.02.2008
(51) Int. Cl.: H01L 21/316, C08J 9/26

(54) **Procede de préparation d' un materiau diélectrique à porosité orientée sur substrat par traitement électromagnétique et/ou photonique**
Herstellungsverfahren eines dielektrischen Materials mit einer auf das Substrat gerichteten Porosität durch elektromagnetische und/oder Photonen-Behandlung
Method of preparing a dielectric material with oriented porosity on a substrate by electromagnetic and/or photonic treatment

(30) Priorité: 23.02.2007 FR 0753451
(43) Date de publication de la demande: 27.08.2008
(73) Titulaire: Commissariat à l'énergie atomique et aux énergies alternatives, 75015 Paris (FR)
(72) Inventeur: ZENASNI, Aziz, 38610 GIERES (FR)
(74) Mandataire: Ahner, Philippe

(56) Documents cités:
- JP-A- 2002 338 229
- US-A1- 2004 096 593
- US-A1- 2005 070 124
- US-A1- 2005 113 472
- GIUNTA P R ET AL: "PREPARATION OF MESOPOROUS SILICA MONOLITHS WITH ORDERED ARRAYS OF MACROCHANNELS TEMPLATED FROM ELECTRIC-FIELD-ORIENTED HYDROGELS" ANGEWANDTE CHEMIE. INTERNATIONAL EDITION, WILEY VCH VERLAG, WEINHEIM, DE, vol. 43, no. 12, mars 2004 (2004-03), pages 1505-1507, XP001237126 ISSN: 1433-7851
- YOSHIKAZU MOTOYAMA ET AL.: "Electrical Properties of SiO2 Films Deposited by Photon-Assisted CVD with Vacuum-Ultraviolet Excimer Lamp" ELECTRONICS AND COMMUNICATION IN JAPAN, PART 2, [Online] vol. 88, no. 3, 8 août 2005 (2005-08-08), pages 36-43, XP002502794 Extrait de l'Internet: URL:http://www3.interscience.wiley.com/cgi -bin/fulltext/109923758/PDFSTART>
- WU J ET AL: "Host-Guest Chemistry Using an Oriented Mesoporous Host: Alignment and Isolation of a Semiconducting Polymer in the Nanopores of an Ordered Silica Matrix" JOURNAL OF PHYSICAL CHEMISTRY. B (ONLINE), AMERICAN CHEMICAL SOCIETY, COLUMBUS, OH, US, vol. 103, no. 13, 1999, pages 2374-2384, XP003007058 ISSN: 1520-5207

## Description

### DOMAINE TECHNIQUE

L'invention a trait à un procédé de préparation d'un matériau diélectrique à porosité orientée, déposé sur un substrat, par traitement électrique et/ou photonique, ce matériau se présentant classiquement sous forme d'une couche mince, à savoir une couche présentant une épaisseur inférieure à 10 *µ*m.

En particulier, l'invention a trait à un procédé de préparation d'un matériau diélectrique à porosité organisée et à faible permittivité, c'est-à-dire présentant généralement une constante diélectrique k inférieure à 3,9, et plus particulièrement d'un matériau à très faible permittivité, connu sous les appellations anglaises « ultra low-k » (2,2<k<3) et « extreme low-k » (1,5<k<2,2), ce matériau étant déposé sur un substrat.

Ce procédé trouve des applications dans le domaine de la microélectronique, notamment dans la réalisation de matériaux sous forme de couches minces utiles dans les interconnexions dans le but d'isoler électriquement les lignes intermétalliques servant à véhiculer le signal électrique et d'éviter les capacités parasites entre celles-ci, et pour la réalisation de tout type de circuit faisant appel à la fonction séparatrice et isolatrice de couches minces.

Ce procédé trouve également des applications pour la réalisation de membranes séparatrices, de membranes de diffusion, de détecteurs moléculaires, de matériaux optiques, de masques polymères.

### ÉTAT DE LA TECHNIQUE ANTÉRIEURE

La miniaturisation des composants microélectroniques allant de pair avec l'augmentation des performances de ceux-ci s'est considérablement développée ces dernières années. Ces avancées se sont accompagnées par le développement de nouveaux matériaux aptes à remplacer les matériaux conventionnellement utilisés et dont les propriétés sont rendues insuffisantes par cette miniaturisation. Notamment, la nécessité de réduire les capacités parasites entre les lignes d'interconnexions incite à l'emploi de nouveaux matériaux diélectriques présentant une très faible permittivité.

L'une des solutions retenues jusqu'à présent a été d'utiliser des matériaux diélectriques poreux, la présence de ces pores contribuant à diminuer la permittivité du matériau, du fait de l'air présent dans ceux-ci.

Pour ce faire, il a notamment été proposé de déposer, sur les zones destinées à être protégées par un matériau diélectrique poreux, un matériau composite comprenant d'une part un matériau diélectrique formant une matrice et, d'autre part, un composé, classiquement de type polymère, dispersé dans la matrice, puis, après réticulation de la matrice, d'en extraire ledit composé de sorte à remplacer les sites occupés par celui-ci dans la matrice par des pores remplis d'air.

Le composé dispersé dans la matrice, qui n'a comme fonction que celle de permettre la formation de pores au sein de cette matrice est appelé « composé porogène ».

Le dépôt du matériau composite peut se faire par voie solution telle que l'enduction centrifuge (connu sous la dénomination anglaise « spin-coating ») et le trempage-retrait (connu sous la dénomination anglaise « dip-coating ») ou encore par voie plasma, telle que la technique de dépôt chimique en phase vapeur assisté par plasma (PECVD pour « Plasma Enhanced Chemical Vapour Deposition »).

L'extraction du composé porogène du type polymère est réalisée, classiquement, par traitement thermique à une température appropriée pour obtenir la décomposition du composé porogène sous l'effet de la chaleur et, de façon concomitante, sa désorption hors de la matrice. Certains travaux montrent aussi que l'utilisation d'une irradiation ultraviolet couplée au recuit thermique permet une meilleure décomposition du composé porogène.

Toutefois, ce type de traitement, utilisé de nos jours de façon classique, génère un matériau poreux présentant une porosité amorphe et désordonnée, et de ce fait une grande faiblesse mécanique. Il est donc difficile d'intégrer ce type de matériau dans des procédés microélectroniques nécessitant par exemple, une étape de polissage chimico-mécanique, car ces matériaux ne présentent pas une résistance mécanique suffisante..

Pour obtenir une porosité plus ordonnée que les matériaux obtenus avec un composé porogène du type polymère décrits ci-dessus, Grosso et al. (J.Mater.Chem, 10 (2000), 2085*)* qui propose de préparer un matériau diélectrique poreux :
- par dépôt sur un substrat en silicium par trempage-retrait d'une couche de solution obtenue par mélange d'une solution éthanolique contenant un précurseur à base de silicium : le tétraéthoxysilane, et un composé tensio-actif ;
- par traitement thermique de la couche déposée de façon à obtenir une réticulation de celle-ci en silice et une élimination du composé tensio-actif.

L'avantage de ce procédé est de permettre l'obtention par voie solution d'une couche de matériau diélectrique poreux présentant une certaine périodicité. Toutefois, ce procédé ne peut pas s'intégrer dans un procédé d'intégration microélectronique. En effet, en microélectronique, les procédés en solution ne sont pas utiles, car ils engendrent des problèmes d'adhérence, de tenue mécanique et de budget thermique.

Il est important de souligner que l'état de l'art ne présente, à l'heure d'aujourd'hui, aucun exemple de réalisation de couches minces à porosité structurée déposées en phase vapeur (tels que la CVD ou, en particulier, la PECVD).

Il existe donc un véritable besoin pour un procédé de préparation qui permette l'obtention d'un matériau diélectrique à porosité orientée par un dépôt en phase vapeur présentant une périodicité de ses propriétés. En particulier, il existe un véritable besoin pour un matériau diélectrique poreux, généralement, sous forme d'une couche mince, présentant une porosité structurée, homogène et organisée présentant, de ce fait, une tenue mécanique plus importante que celle des matériaux obtenus avec les procédés de l'art antérieur et qui puissent conserver leur intégrité physique lors de traitements ultérieurs, tels qu'un polissage chimico-mécanique.

### EXPOSÉ DE L'INVENTION

La présente invention a donc pour objet un procédé de fabrication d'un matériau diélectrique à porosité orientée sur un substrat comprenant :
a) le dépôt en phase vapeur sur un substrat d'une couche composite, comprenant un matériaudiélectrique formant une matrice et un composé porogène décomposable comprenant des groupes chimiques aptes à s'orienter sous l'effet d'un champ électrique et/ou d'un rayonnement photonique ;
b) le traitement de la couche composite pour obtenir la réticulation du matériau formant une matrice ;
ledit procédé comprenant, en outre, une étape c) consistant à soumettre ledit substrat revêtu de ladite couche composite à un champ électrique et/ou un rayonnement photonique, ladite étape c) étant réalisée simultanément à l'étape a), lorsque l'on soumet ladite couche à un rayonnement photonique ou réalisée avant et/ou simultanément à l'étape b), lorsque l'on soumet ladite couche à un champ électrique, sachant que le champ électrique est appliqué au contact du substrat, cette étape c) étant réalisée de sorte à aligner selon une direction prédéterminée les groupes chimiques mentionnées à l'étape a);
ledit procédé comprenant, en outre, une étape d) consistant à traiter la couche composite pour obtenir une décomposition du composé porogène et ainsi son extraction.

Ainsi, le caractère innovant de ce procédé de l'invention réside essentiellement dans la combinaison de l'étape a) et l'étape c), du fait que ces étapes vont contribuer à favoriser un alignement des molécules de composés, qui auront pour aptitude de s'agencer suivant une direction privilégiée selon la perturbation appliquée, grâce à la nature des groupes chimiques spécifiques portées par ces composés. Ces composés alignés selon une direction privilégiée vont contribuer à conférer au matériau une périodicité des propriétés inhérentes à la nature de ces composés.

Conformément à l'invention, l'étape de mise en contact du substrat revêtu de la couche avec un champ électrique et/ou un rayonnement photonique peut être réalisée de différentes façons.

Ainsi, cette étape c) peut se dérouler avant l'étape b), c'est-à-dire, par exemple, soit simultanément à l'étape a) de dépôt, ce qui est possible lorsque le traitement se fait par rayonnement photonique ou par champ électrique, soit une fois que l'étape de dépôt a) est achevée, ce qui est possible uniquement lorsque le traitement se fait par champ électrique, sachant qu'il est préférable, dans les deux cas, de mettre en oeuvre cette étape c) simultanément à l'étape de dépôt a). En effet, dans ce dernier cas, le champ électrique et/ou le rayonnement photonique permettront un alignement des molécules de composés dès le dépôt de ceux-ci sur le substrat et permettront un agencement préférentiel de ceux-ci sur toute l'épaisseur de la couche déposée. Qui plus, lorsque l'étape c) est réalisée simultanément à l'étape a), le matériau composite est, généralement, faiblement réticulé, ce qui permet une meilleure orientation des composés susmentionnés. Pour ce faire, le dépôt du matériau composite peut se faire dans des conditions douces (telles qu'une pression P > 2 torrs, une température inférieure ou égale à 300°C et une puissance inférieure à 500 Watts). A titre d'exemple, lorsque le matériau est à base de silice, plus de 1% de groupes -SiOH doivent être avantageusement incorporés dans la couche (ce taux pouvant être vérifié par analyse infra-rouge).

Comme mentionné ci-dessus, le traitement par rayonnement photonique peut être mis en oeuvre uniquement simultanément à l'étape de dépôt a), et ce pour permettre une orientation progressive des composés aptes à s'aligner. En effet, une fois la couche déposée en phase vapeur, le rayonnement photonique, si appliqué après l'étape de dépôt, ne serait plus capable d'engendrer une orientation des molécules, du fait de l'inertie des molécules dans un réseau contraint et la faible interaction rayonnement-matière. On note également que l'on distingue un rayonnement photonique utilisé pour la dégradation, du rayonnement photonique de l'invention, celui-ci étant mis en oeuvre dans ce cas sans étape de recuit thermique (du fait que le rayonnement intervient simultanément au dépôt), et ce afin d'éviter la dégradation des composés aptes à s'orienter lors de l'application du rayonnement photonique.

Pour le traitement par un champ électrique, cette étape c) peut se dérouler simultanément à l'étape a), après cette étape a) mais avant l'étape b) et/ou encore simultanément à cette étape b).

Enfin, il est également envisageable de mettre en oeuvre l'étape c) à la fois avant l'étape b) et simultanément à cette étape.

Quelle que soit l'alternative retenue quant au déroulement temporel de l'étape c), le champ électrique appliqué est, avantageusement, selon l'invention, une tension électrique appliquée directement au substrat revêtu de la couche. De manière préférentielle, la tension électrique est une tension continue, de façon à ce que les molécules de composé s'agencent selon une phase donnée de la même façon irréversible, c'est-à-dire toujours selon la même direction imposée par le champ électrique. La tension électrique, de préférence continue, peut être comprise entre 1 V et 100 V. Il peut être envisageable, selon la nature du composé utilisé, de faire évoluer la tension par palier de 1 V jusqu'à trouver un point de fonctionnement. Le point de fonctionnement correspond à la tension, pour laquelle les molécules de composés s'agencent de façon invariable.

Le rayonnement photonique peut être quant à lui, un rayonnement ultraviolet. Selon la nature des groupes chimiques du composé apte à s'orienter sous l'influence du rayonnement UV, il sera opportun de régler :
- la longueur d'onde du rayonnement ultraviolet, de façon à ce que les groupes aptes à s'orienter puissent absorber ce rayonnement et s'orienter une fois l'absorption réalisée ;
- l'intensité du rayonnement de façon à ce qu'elle s'accorde avec le spectre d'absorption des groupes appropriés du composé.

L'intensité du rayonnement peut varier, par exemple, entre 1 et 5 eV. Il peut être envisageable, en fonction des groupes photosensibles présents sur le composé, de faire varier graduellement la longueur d'onde de la source UV afin de trouver un point de fonctionnement.

Le procédé de l'invention s'applique à la préparation d'un matériau diélectrique à porosité organisée, le matériau formant une matrice étant un matériau diélectrique et le composé comprenant des groupes chimiques aptes à s'orienter sous l'effet d'un champ électrique et/ou d'un rayonnement photonique étant un composé porogène décomposable, ce composé n'étant, de préférence, pas apte à s'organiser sous forme de cristaux liquides.

Le procédé comprend, en outre, une étape d) consistant à traiter la couche composite pour obtenir une décomposition du composé porogène et ainsi son extraction.

Les pores résultant de l'élimination de ces composés porogènes seront donc orientés, de façon homogène, et selon une direction privilégiée, du fait qu'ils héritent de la place des molécules de composés homogènes après élimination de celles-ci.

Dans ce cas de figure, l'étape c) consistant à soumettre ledit substrat revêtu de ladite couche à un rayonnement photonique se déroulera toujours simultanément à l'étape a).

Dans le cas d'un traitement par champ électrique, l'étape c)peut se dérouler avant les étapes b) et/ou d), c'est-à-dire, par exemple, soit simultanément à l'étape a) de dépôt, soit une fois que l'étape de dépôt a) est achevée, sachant qu'il est préférable de mettre en oeuvre cette étape c) simultanément à l'étape de dépôt a). En effet, dans ce dernier cas, le champ électrique permettra un alignement des molécules de composés porogènes dès le dépôt de ceux-ci sur le substrat et un agencement préférentiel de ceux-ci sur toute l'épaisseur de la couche déposée.

En variante, pour le traitement par champ électrique, cette étape c) peut se dérouler simultanément aux étapes b) et/ou d).

Enfin, il est également envisageable de mettre en oeuvre l'étape c) à la fois avant les étapes de traitement b) et/ou d) et simultanément l'étape b).

Conformément à l'invention, le matériau diélectrique formant la matrice peut être tout matériau, de préférence à base de silicium, connu pour présenter des propriétés diélectriques.

Il peut s'agir de SiO₂, SiOC, de carbure de silicium (SiC), de carbure de silicium hydrogéné (SiC :H), d'oxynitrure de silicium (Si :O :N), de nitrure de silicium (SiN), de carbonitrure de silicium (Si :CN), de verres fluorés (SiOF), d'organofluorosilicates (Si :O :C :H :F), de composés organosiliciés (SiOCH), de verres borosilicatés (Si :OBHP), BHP signifiant respectivement bore, hydrogène, phosphore.

Il peut s'agir également d'un matériau carboné, tel qu'un matériau en carbone cristallisé selon le système cristallin propre au diamant (intitulé souvent carbone DLC).

Avantageusement, le dépôt peut être réalisé par dépôt chimique en phase vapeur assisté par plasma (connu sous l'abréviation PECVD pour « Plasma *Enhanced Chemical Vapour Deposition* »). Cette technique est particulièrement adaptée lorsque le matériau formant matrice est un matériau du type SiO₂, SiOC ou SiOF.

D'autres méthodes peuvent être utilisées en complément de la PECVD, telles que la PECVD haute densité (ADP), la CVD assisté par photons (notamment dans le cas d'utilisation du rayonnement photonique pour l'orientation), la CVD cryogénique, la CVD assistée par filament.

Les substrats mis en oeuvre selon l'invention, peuvent être des substrats semiconducteurs GaAs (arséniure de gallium), en alliage SiGe, en boronitrure de silicium, des substrats contenant du silicium tels que le silicium épitaxial, le dioxyde de silicium SiO₂, les carbures de silicium (SiC), le SiCN, les matériaux SiOCH, SiOCF.

Dans le cas d'un dépôt par PECVD, une source de matériau diélectrique destiné à former la matrice et une source de composé apte à s'orienter sont conjointement ou successivement injectées sous forme de vapeur dans l'enceinte d'un réacteur plasma. Dans le cas de précurseurs se présentant sous forme liquide, ceux-ci sont portés préalablement à une température supérieure à leur température d'ébullition. Dans ce type de technique, les sources peuvent être dédoublées, c'est-à-dire qu'il peut être utilisé plusieurs sources de matériau diélectrique et éventuellement plusieurs sources de composés aptes à s'orienter. Une fois les sources injectées, on applique une tension sous forme de différence de potentiel, généralement entre deux électrodes parallèles placées dans une enceinte sous vide, de façon à engendrer une décharge plasma. On précise que, par plasma, on entend un milieu gazeux constitué d'électrons libres, d'ions et d'atomes ou de molécules neutres, ces particules étant en proportions telles que le milieu soit macroscopiquement neutre du point de vue électrique. La source initiatrice de plasma peut être, par exemple, une tension radiofréquence. L'état plasma permet notamment, selon la puissance électromagnétique injectée, de conserver ou fragmenter les molécules des précurseurs injectés.

Les molécules constitutives de la matrice et/ou des composés aptes à s'orienter doivent pouvoir être injectées dans une enceinte plasma sous vide, sous forme de vapeur (gaz). Ces injections peuvent être mises en place par diverses méthodes, telles que la méthode à l'hélium pousseur. Les molécules utilisées devront avantageusement présenter une valeur de pression saturante compatible avec une évaporation et une injection sous forme vapeur.

Un substrat, par exemple, en silicium, relié à l'une des électrodes, sert de substrat de dépôt. Le fait que ce substrat soit relié à une électrode permet d'imposer une température à ce substrat, de façon à faciliter le dépôt sur le substrat, cette température pouvant aller de la température ambiante à une température de 300°C. Il peut être envisageable d'augmenter la température par palier de 25°C. Sous l'effet de la gravitation et de la diffusion des espèces dans le plasma, les molécules provenant du précurseur de la matrice et du composé vont conjointement s'adsorber sur la surface du substrat et faire donc croître le dépôt.

Selon l'invention, le composé porogène déposé doit comporter des groupes aptes à s'orienter sous l'effet du champ électrique et/ou d'un rayonnement photonique et, qui plus est, doit pouvoir être décomposé au cours de l'étape d). Par décomposable, on entend un composé susceptible de perdre son intégrité physique sous l'effet d'une perturbation, par exemple thermique, et qui peut se décomposer en substances volatiles, facilitant ainsi son extraction. Ce composé porogène est décomposé au cours de l'étape d) par traitement thermique en le chauffant à une température supérieure ou égale à sa température de décomposition, ceci ayant pour effet de volatiliser et extraire les molécules de composé porogène et permettre la formation de pores au sein du matériau diélectrique formant matrice. La température égale ou supérieure à la température de décomposition du composé porogène peut être obtenue en portant le substrat à la température appropriée, le substrat faisant office de plaque chauffante, ce chauffage pouvant avoir lieu soit dans le réacteur de dépôt, soit dans un four indépendant du réacteur de dépôt. L'homme du métier pourra atteindre une telle température, par exemple, par palier de 25°C. Outre un chauffage sur plaque chauffante, la décomposition thermique du composé porogène peut être obtenue par exposition à une radiation, une énergie mécanique ou par irradiation par particules.

Outre la décomposition thermique, le traitement de l'étape d) peut être envisagé par extraction par solvant (par exemple par CO₂ supercritique) ou par gravure chimique (par exemple, par plasma d'hydrogène).

Le composé porogène ainsi décomposé diffuse à l'extérieur du matériau diélectrique formant matrice ou diffuse à l'intérieur du matériau diélectrique, formant dans les deux cas des zones non occupées, vides, appelées pores, qui permettent de réduire la permittivité du matériau diélectrique formant matrice.

Avantageusement, le rapport molaire (composé porogène/matrice diélectrique) est inférieur ou égal à 0,5.

Avantageusement, le composé porogène est un polymère. Ainsi, en se décomposant, il pourra engendrer des pores de structure tubulaire, du fait de l'espace vacant laissé par les chaînes polymériques.

Comme mentionné précédemment, le composé porogène comporte des groupes aptes à s'orienter sous l'effet d'un champ électrique, ou d'un rayonnement photonique.

Des groupes susceptibles de s'orienter sous l'effet d'un champ électrique peuvent être des groupes polaires pouvant être choisis parmi les groupes -OH (en particulier, -SiOH), -CN, les groupes hétérocycliques, -CO₂H, esters, -SiC, -SiF, - SiNH, -CF, -NH, -F.

Ainsi, le composé porogène peut être avantageusement un polymère obtenu par polymérisation d'au moins un monomère éthylénique comportant un groupe polaire choisi parmi :
a) les monomères éthyléniques comportant un ou plusieurs groupes -CO₂H et leurs esters et les monomères éthyléniques comportant un ou plusieurs groupes CN, tels que :
   - les (méth)acryliques, éventuellement substitués, comme l'acide acrylique, l'acide méthacrylique ou l'acide crotonique ;
   - les (méth)acrylates d'alkyles et d'alkylènes comme les (méth)acrylates de méthyle, d'éthyle, de propyle, de butyle, d'octyle, de 2-éthyl-hexyle, de cyclohexyle ou de 2-hexène, et leurs dérivés obtenus par substitution desdits alkyles et alkylènes comme les (méth)acrylates de méthoxyéthyle, d'éthoxy-éthyle, d'éthoxypropyle, d'hexafluoroisopropyle, de 2-hydroxyéthyle, de 2- ou 3-hydroxypropyle, de 2,3-dihydroxypropyle, de polyéthoxyéthyle ou de polyéthoxy-propyle ;
   - les (méth)acrylates d'aryles tels que les (méth)acrylates de phényle ou de benzyle, et leurs dérivés obtenus par substitution desdits aryles ;
   - les (méth)acrylates et di(méth)acrylates de poly(éthylène glycol) ou de poly(propylène glycol) ;
   - les (méth)acrylamides et leurs dérivés N-substitués comme le N-méthylacrylamide, le N,N-diméthylacrylamide, le N,N-diméthylméthacrylamide, l'acide 2-acrylamido-2-méthyl-1-propanesulfonique, le N-[3-(diméthylamino)propyl]acrylamide ou le 2-(N,N-diéthyl-amino)éthylméthacrylamide ;
   - les acides dicarboxyliques insaturés comme l'acide maléique, l'acide fumarique ou l'acide itaconique, et leurs esters comme le maléate de diméthyle, le fumarate de diméthyle ou le fumarate de diéthyle ;
   - les monomères nitrilés comme l'acrylo-nitrile ;
b) les monomères éthyléniques comportant un groupe hétérocyclique tels qu'un cycle pyridine (par exemple, la 2-vinylpyridine, la 4-vinylpyridine, la 2-méthyl-5-vinylpyridine, la 4-méthyl-5-vinylpyridine ou la N-méthyl-4-vinylpyridine), un cycle pipéridine (par exemple, la N-méthyl-4-vinylpipéridine), un cycle imidazole (par exemple, le 2-méthyl-1-vinylimidazole), un cycle pyrrolidone (par exemple, la N-vinyl-pyrrolidone) ou encore un cycle pyrroledione (par exemple, le maléimide) ;
c) les monomères éthyléniques comportant un groupe -O-CO-R avec R représentant un groupe alkyle (par exemple, l'acétate de vinyle ou le propionate de vinyle), ou un groupe aryle (par exemple, le benzoate de vinyle) ;
d) les monomères éthyléniques comportant un groupe -OR, connus sous la terminologie de vinyléthers, avec R représentant un groupe alkyle (par exemple, le méthylvinyléther), ledit groupe pouvant comporter un ou plusieurs atomes d'oxygène (par exemple, l'éthoxyéthyl-vinyléther) ou un ou plusieurs groupes amino (par exemple, le diméthylaminoéthylvinyléther) ; et
e) les monomères éthyléniques comprenant un groupe -C(O)R avec R représentant un groupe alkyle (par exemple, la vinylméthylcétone
   et éventuellement d'un ou plusieurs monomères choisis parmi :
   - les monomères éthyléniques comportant un groupe aromatique exclusivement hydrocarboné tels que le styrène ou l'α-méthylstyrène ;
   - les monomères éthyléniques exclusivement hydrocarbonés comme le 1-hexène, le norbornène ou l'acénaphtylène.

En particulier, des polymères susceptibles de constituer des composés porogènes aptes à s'orienter sous l'effet d'un champ électrique, sont des copolymères (acrylonitrile/butadiène), des copolymères (styrène/acrylonitrile), des polyvinylpyrrolidines, des cyclodextrines.

Des groupes susceptibles de s'orienter sous l'effet d'un rayonnement photonique peuvent être des groupes azo -N=N-.

Des composés porogènes répondant à ce critère sont des polymères linéaires obtenus par photopolymérisation de monomères tels que les azobenzènes ou des polymères réticulés obtenus par photopolymérisation de prépolymères comportant des groupes susceptibles de se réticuler (dit groupe de réticulation) et des monomères, oligomère ou polymères comportant des groupes aptes à réagir des groupes de réticulation, le polymère résultant comportant des groupes photoorientables.

Selon l'invention, l'étape b) et l'étape d) peuvent être mises en oeuvre simultanément.

L'étape de traitement b) destinée à engendrer la réticulation du matériau diélectrique formant matrice consiste généralement en un chauffage du substrat à une température efficace pour engendrer la réticulation. On précise que, par réticulation, on entend une réaction engendrant un branchement des chaînes de la matrice entre elles par des ponts ou liaisons chimiques, afin de constituer un réseau présentant des propriétés physico-chimiques, telles que la rigidité, supérieures à la couche de matériau initialement déposée.

L'étape d) est réalisée avantageusement par chauffage à une température efficace pour obtenir une décomposition du composé porogène.

Dans le cas où cette étape b) est mise en oeuvre simultanément à l'étape d), le chauffage permettra de décomposer, de façon concomitante, le composé porogène. Les moyens de chauffage pour réticuler le matériau diélectrique peuvent être similaires à ceux décrits plus haut pour la décomposition du composé porogène. Cette étape de chauffage du matériau diélectrique formant matrice en vue de le réticuler, peut être qualifiée de « recuit », ce recuit pouvant être assisté par un rayonnement ultra-violet, un faisceau d'électrons, par plasma H₂, en fluide supercritique (tel que CO₂).

L'étape b) et l'étape d) doivent être réalisées à une température efficace, ces températures efficaces pouvant être déterminées aisément, de façon à obtenir le but voulu, à savoir la réticulation et/ou la décomposition du composé porogène.

En particulier, les températures seront choisies, de façon à obtenir un matériau stabilisé répondant, avantageusement, aux critères suivants :
- un bon vieillissement ;
- une reprise d'humidité inférieure à 1% (déterminée par pesage) ;
- une constante diélectrique stable (écart inférieur à 0,05) ;
- une bonne tenue mécanique, le film ne devant ni délaminer ni craqueler lors d'une étape de polissage mécano-chimique, tel qu'un polissage mécano-chimique avec une suspension à base de particules colloïdales de silice à pH basique (pH de l'ordre de 8) ;
- une tenue thermique, le film devant être stable jusqu'à 450°C (perte en masse inférieure à 5%) ;
- une inertie physico-chimique, les mesures ellipsométriques et de stress devant restées constantes, et ne présentant pas d'apparition de nouvelles liaisons adsorbées sur le spectre infrarouge au cours du temps.

L'ensemble des étapes est réalisé avantageusement à une pression supérieure à 5 torrs.

Ainsi, le procédé de l'invention peut permettre l'obtention d'un matériau diélectrique à porosité organisée, en particulier sous forme d'une couche mince, et à faible permittivité, c'est-à-dire présentant généralement une constante diélectrique k inférieure à 3,9, et plus particulièrement d'un matériau à très faible permittivité, connu sous les appellations anglaises « ultra low-k » (2,2<k<3) et « extreme low-k » (1,5<k<2,2).

Outre des applications dans le domaine de la microélectronique, ces matériaux peuvent trouver leur application dans le domaine de la catalyse, des membranes séparatrices, des capteurs chimiques et des interconnexions optiques.

### EXPOSÉ DÉTAILLÉ DE MODES DE RÉALISATION PARTICULIERS

### EXEMPLE 1

Une plaque de silicium est déposée sur un substrat chauffant.

Sur cette plaque de silicium est déposée, par PECVD assisté par photons, une couche de SiOC (matériau formant une matrice) comprenant un composé porogène par injection :
- d'un composé organosilicié : le tétraéthoxysilane, précurseur de la couche de SiOC ;
- d'un composé porogène comprenant des groupes photosensibles : un diaryléthène
selon un rapport de débit de composé porogène par rapport au composé organosilicié de 2.

Pendant l'étape de dépôt, un rayonnement ultraviolet de 10 mW à une longueur d'onde de 325 nm est appliqué en irradiant le substrat revêtu de la couche, moyennant quoi les molécules du composé porogène adsorbées à la surface du substrat s'orientent selon une direction donnée. Enfin, le substrat revêtu de la couche est soumis à un chauffage à une température de 425°C pendant 1 heure, moyennant quoi le composé porogène est éliminé et le composé organosilicié est réticulé. On obtient ainsi une couche diélectrique présentant une porosité agencée régulièrement.

## Revendications

1. Procédé de fabrication d'un matériau diélectrique à porosité orientée sur un substrat comprenant :
a) le dépôt en phase vapeur sur un substrat d'une couche composite, comprenant un matériau diélectrique formant une matrice et un composé porogène décomposable comprenant des groupes chimiques aptes à s'orienter sous l'effet d'un champ électrique et/ou d'un rayonnement photonique ;
b) le traitement de la couche composite pour obtenir la réticulation du matériau formant une matrice ;
ledit procédé comprenant, en outre, une étape c) consistant à soumettre ledit substrat revêtu de ladite couche composite à un champ électrique et/ou un rayonnement photonique, ladite étape c) étant réalisée simultanément à l'étape a), lorsque l'on soumet ladite couche à un rayonnement photonique ou étant réalisée avant et/ou simultanément à l'étape b), lorsque l'on soumet ladite couche à un champ électrique, sachant que le champ électrique est appliqué au contact du substrat, cette étape c) étant réalisée de sorte à aligner selon une direction prédéterminée les groupes chimiques mentionnées à l'étape a) ;
ledit procédé comprenant, en outre, une étape d) consistant à traiter la couche composite pour obtenir une décomposition du composé porogène et ainsi son extraction.

2. Procédé selon la revendication 1, dans lequel le champ électrique est issu d' une tension électrique appliquée directement au substrat revêtu de la couche.

3. Procédé selon la revendication 2, dans lequel la tension électrique est comprise entre 1 V et 100 V.

4. Procédé selon la revendication 1, dans lequel le rayonnement photonique est un rayonnement ultraviolet appliqué simultanément à l'étape a).

5. Procédé selon l'une quelconque des revendications précédentes, dans lequel l'étape c) consistant à soumettre ledit substrat revêtu de ladite couche à un champ électrique est réalisée avant et/ou simultanément aux étapes b) et/ou d).

6. Procédé selon l'une quelconque des revendications précédentes, dans lequel le matériau diélectrique formant une matrice est un matériau silicié non polymérique.

7. Procédé selon la revendication 6, dans le matériau est un matériau à base de silicium choisi parmi SiO₂, SiOC, SiOF, SiC, les carbures de silicium hydrogénés, les oxynitrures de silicium, les nitrures de silicium, les carbonitrures de silicium, les verres fluorés, les composés organofluorosilicates, les composés organosiliciés, les verres borosilicatés.

8. Procédé selon l'une quelconque des revendications précédentes, dans lequel l'étape de dépôt est réalisée par dépôt chimique en phase vapeur assisté par plasma.

9. Procédé selon l'une quelconque des revendications précédentes, dans lequel le composé porogène est un polymère.

10. Procédé selon la revendication 9, dans lequel le polymère résulte de la polymérisation d'au moins un monomère éthylénique comportant un groupe polaire choisi parmi :
- les monomères éthyléniques comportant un ou plusieurs groupes -CO₂H et leurs esters et les monomères éthyléniques comportant un ou plusieurs groupes CN ;
- les monomères éthyléniques comportant un groupe hétérocyclique;
- les monomères éthyléniques comportant un groupe -O-CO-R avec R représentant un groupe alkyle, ou un groupe aryle;
- les monomères éthyléniques comportant un groupe -OR avec R représentant un groupe alkyle, ledit groupe pouvant comporter un ou plusieurs atomes d'oxygène ou un ou plusieurs groupes amino; et
- les monomères éthyléniques comprenant un groupe -C(O)R avec R représentant un groupe alkyle ;
et éventuellement d'un ou plusieurs monomères choisis parmi :
- les monomères éthyléniques comportant un groupe aromatique exclusivement hydrocarboné;
- les monomères éthyléniques exclusivement hydrocarbonés.

11. Procédé selon l'une quelconque des revendications précédentes, dans lequel l'étape b) est réalisée par chauffage à une température efficace pour obtenir une réticulation du matériau formant la matrice.

12. Procédé selon l'une quelconque des revendications précédentes, dans lequel l'étape d) est réalisée par chauffage à une température efficace pour obtenir une décomposition du composé porogène.

13. Procédé selon l'une quelconque des revendications précédentes, dans lequel l'étape b) et l'étape d) sont réalisées simultanément.

## Patentansprüche

1. Verfahren zur Herstellung eines dielektrischen Materials mit einer auf ein Substrat gerichteten Porosität, umfassend:
a) Dampfphasenabscheidung einer Verbundschicht auf ein Substrat, die ein dielektrisches Material enthält, das eine Matrix bildet, und eine zersetzbare porenbildende Verbindung, die chemische Gruppen enthält, die dazu geeignet sind, sich unter der Wirkung eines elektrischen Feldes und/oder einer Photonenstrahlung auszurichten;
b) Behandeln der Verbundschicht, um die Vernetzung des eine Matrix bildenden Materials zu erhalten;
wobei das Verfahren ferner einen Schritt c) umfasst, der darin besteht, das mit der Verbundschicht beschichtete Substrat einem elektrischen Feld und/oder einer Photonenstrahlung auszusetzen, wobei der Schritt c) gleichzeitig mit dem Schritt a) dann durchgeführt wird, wenn die Schicht der Photonenstrahlung ausgesetzt wird, oder vor und/oder gleichzeitig mit Schritt b) dann durchgeführt, wenn die Schicht einem elektrischen Feld ausgesetzt wird, wobei das elektrische Feld in Kontakt mit dem Substrat angelegt wird, wobei dieser Schritt c) so durchgeführt wird, dass die in Schritt a) genannten chemischen Gruppen in einer vorbestimmten Richtung ausgerichtet werden; wobei das Verfahren ferner einen Schritt d) umfasst, der darin besteht, die Verbundschicht zu behandeln, um eine Zersetzung der porenbildenden Verbindung und damit deren Extraktion zu erhalten.

2. Verfahren nach Anspruch 1, wobei das elektrische Feld von einer elektrischen Spannung stammt, die direkt an das mit der Schicht beschichtete Substrat angelegt wird.

3. Verfahren nach Anspruch 2, wobei die elektrische Spannung zwischen 1 V und 100 V beträgt.

4. Verfahren nach Anspruch 1, wobei die Photonenstrahlung eine UV-Strahlung ist, die gleichzeitig mit Schritt a) angewendet wird.

5. Verfahren nach einem der vorangehenden Ansprüche, wobei der Schritt c), der darin besteht, das mit der Schicht beschichtete Substrat einem elektrischen Feld auszusetzen, vor und/oder gleichzeitig mit den Schritten b) und/oder d) durchgeführt wird.

6. Verfahren nach einem der vorangehenden Ansprüche, wobei das eine Matrix bildende dielektrische Material ein nicht-polymeres Siliciummaterial ist.

7. Verfahren nach Anspruch 6, wobei das Material ein Material auf Basis von Silicium ist, ausgewählt aus SiO₂, SiOC, SiOF, SiC, hydrierten Siliciumcarbiden, Siliciumoxynitriden, Siliciumnitriden, Siliciumcarbonitriden, fluorierten Gläsern, Organofluorosilicatverbindungen, Organosiliciumverbindungen, Borosilicatgläsern.

8. Verfahren nach einem der vorangehenden Ansprüche, wobei der Schritt der Abscheidung durch plasmagestützte chemische Dampfphasenabscheidung erfolgt.

9. Verfahren nach einem der vorangehenden Ansprüche, wobei die porenbildende Verbindung ein Polymer ist.

10. Verfahren nach Anspruch 9, wobei das Polymer aus der Polymerisation von mindestens einem ethylenischen Monomer resultiert, umfassend eine polare Gruppe, ausgewählt aus:
- ethylenischen Monomeren mit einer oder mehreren -CO₂H-Gruppen und deren Estern und ethylenischen Monomeren mit einer oder mehreren CN-Gruppen;
- ethylenischen Monomeren mit einer heterocyclischen Gruppe;
- ethylenischen Monomeren mit einer Gruppe -O-CO-R-Gruppe, wobei R eine Alkylgruppe oder eine Arylgruppe darstellt;
- ethylenischen Monomeren mit einer -OR-Gruppe, wobei R eine Alkylgruppe darstellt, wobei die Gruppe ein oder mehrere Sauerstoffatome oder eine oder mehrere Aminogruppen umfassen kann; und
- ethylenischen Monomeren mit einer -C(O)R-Gruppe, wobei R eine Alkylgruppe darstellt;
sowie gegebenenfalls von einem oder mehreren Monomeren, ausgewählt aus:
- ethylenischen Monomeren mit einer ausschließlich kohlenwasserstoffhaltigen aromatischen Gruppe;
- ausschließlich kohlenwasserstoffhaltigen ethylenischen Monomeren.

11. Verfahren nach einem der vorangehenden Ansprüche, wobei der Schritt b) durch Erhitzen auf eine effektive Temperatur durchgeführt wird, um eine Vernetzung des die Matrix bildenden Materials zu erhalten.

12. Verfahren nach einem der vorangehenden Ansprüche, wobei der Schritt d) durch Erhitzen auf eine effektive Temperatur durchgeführt wird, um eine Zersetzung der porenbildenden Verbindung zu erhalten.

13. Verfahren nach einem der vorangehenden Ansprüche, wobei der Schritt b) und der Schritt d) gleichzeitig durchgeführt werden.

## Claims

1. Method for producing an oriented-porosity dielectric material on a substrate comprising:
a) vapour phase deposition on a substrate of a composite layer, comprising a material forming a matrix and a decomposable pore-forming compound comprising chemical groups capable of being oriented under the effect of an electric field and/or photonic radiation;
b) the treatment of the composite layer to obtain the cross-linking of the material forming a matrix;
said method also comprising a step c) consisting of subjecting said substrate coated with said composite layer to an electric field and/or a photonic radiation, said step c) being carried out simultaneously with step a), when said layer is subjected to a photonic radiation or carried out before and/or simultaneously with step b), when said layer is subjected to an electric field, given that the electric field is applied in contact with the substrate, said step c) being carried out so as to align the chemical groups mentioned in step a) in a predetermined direction,
said method also comprising a step d) consisting of treating the composite layer to obtain a decomposition of the pore-forming compound and thus the extraction thereof.

2. Method according to claim 1, wherein the electric field comes from an electric voltage applied directly to the substrate coated with the layer.

3. Method according to claim 2, wherein the electric voltage is between 1 V and 100 V.

4. Method according to claim 1, wherein the photonic radiation is an ultraviolet radiation applied simultaneously with step a).

5. Method according to any of the above claims, wherein step c) consisting of subjecting said substrate coated with said layer to a photonic radiation is performed before and/or simultaneously with steps b) and/or d).

6. Method according to any of the above claims, wherein the dielectric material forming a matrix is a non-polymeric silicate material.

7. Method according to claim 6, wherein the material is silicon-based material selected from Si, SiO₂, SiOC, SiOF, SiC, hydrogenated silicon carbides, silicon oxynitrides, silicon nitrides, silicon carbonitrides, fluorinated glass, organofluorosilicate compounds, organosilicate compounds, borosilicate glass.

8. Method according to any of the above claims, wherein the deposition step is performed by means of plasma enhanced chemical vapour deposition.

9. Method according to any of the above claims, wherein the pore-forming compound is a polymer.

10. Method according to claim 9, wherein the polymer results from the polymerisation of at least one ethylenic monomer comprising a polar group selected from:
- ethylenic monomers comprising one or more -CO₂H groups and the esters thereof and ethylenic monomers comprising one or more CN groups;
- ethylenic monomers comprising a heterocyclic group;
- ethylenic monomers comprising an -O-CO-R group where R represents an alkyl group, or an aryl group;
- ethylenic monomers comprising an -OR group, where R represents an alkyl group, said group possibly comprising one or more oxygen atoms or one of more amino groups; and
- ethylenic monomers comprising a -C(O)R group where R represents an alkyl group;
and, possibly, one or more monomers selected from:
- ethylenic monomers comprising an exclusively hydrocarboneous aromatic group;
- exclusively hydrocarboneous ethylenic monomers.

11. Method according to any of the above claims, wherein step b) is performed by heating to an effective temperature to obtain cross-linking of the material forming the matrix.

12. Method according to any of the above claims, wherein step d) is performed by heating to an effective temperature to obtain a decomposition of the pore-forming compound.

13. Method according to any of the above claims, wherein step b) and step d) are performed simultaneously.
